Europäisches Patentamt

European Patent Office

Office européen des brevets

(11) Publication number: **0 411 640 A2**

# EUROPEAN PATENT APPLICATION

(21) Application number: 90114877.5

(22) Date of filing: 02.08.90

(51) Int. Cl.⁵: **G11C 19/18**, G11C 21/00

(30) Priority: 04.08.89 JP 202650/89
11.08.89 JP 208815/89

(43) Date of publication of application:
06.02.91 Bulletin 91/06

(84) Designated Contracting States:
DE FR GB

(71) Applicant: **OLYMPUS OPTICAL CO., LTD.**
**43-2, 2-chome, Hatagaya Shibuya-ku**
**Tokyo 151(JP)**

(72) Inventor: **Morimoto, Masamichi**
**2-11-4-201, Bessyo**
**Hachioji-shi, Tokyo(JP)**
Inventor: **Imai, Masaharu**
**1474-2, Higashi, Sakai-ku**
**Ina-shi, Nagano-ken(JP)**
Inventor: **Nakano, Hiroshi**
**560-11, Kitano-machi**
**Hachioji-shi, Tokyo(JP)**
Inventor: **Fujii, Masayuki**
**6-14-5-527, Oowada-machi**
**Hachioji-shi, Tokyo(JP)**
Inventor: **Nakamura, Junichi**
**5298 Oguro, Nishimachi-ku**
**Ina-shi, Nagano-ken(JP)**
Inventor: **Nakamura, Tsutomu**
**2545-1, Yamamoto-cho, Yamadera-ku**
**Ina-shi, Nagano-ken(JP)**

(74) Representative: **Kuhnen, Wacker & Partnerner**
**Schneggstrasse 3-5 Postfach 1553**
**D-8050 Freising(DE)**

(54) **Three-dimensional integrated memory.**

(57) A three-dimensional integrated memory which integrates a plurality of multi-layer memory elements (30a) each being composed of alternately laminated conductive films and tunnel switch films in matrix formation on an XY plane. X- and Y-decoders (32, 34) select optional multi-layer memory elements one by one from the plurality of multi-layer memory elements, and output data signals to the selected multi-layer memory elements respectively. A plurality of interfaces (37) are respectively set to one-ends of the integrated multi-layer memory elements on the identical side, and includ capacitors (Cd) for storing the data signals, a signal (WRT) simultaneously writes data signals stored in the capacitors into the plurality of multi-layer memory elements.

F I G. 5

## THREE-DIMENSIONAL INTEGRATED MEMORY

The present invention relates to a three-dimensional integrated memory which is integrally composed of multi-layer memory elements based on two-dimensions.

Recently, reflecting significant development of highly sophisticated information media in modern society, a wide variety of information transmission/receiving apparatuses have been introduced at large. Reflecting this, users demand still higher performance potentials of memory elements which share part of the most important component of these sophisticated apparatuses.

On the other hand, manufactures used to follow up studies in pursuit of ultra-fine dimensions of LSIs available for modern electronics. Nevertheless, it appears that there is a certain limit in the art of developing still finer size of LSIs today. Reflecting this, manufactures now follow up studies for developing three-dimensional memory elements in order to materialize higher-density integration, more sophisticated function, and faster operating speed of these memory elements.

To materialize such a three-dimensional integrated circuit, there are a variety of conventional arts including the following; SOI (silicon on insulator) and SIMOX (separation by implanted oxident) based on the utilization of silicon, an art combining III-group elements with V-group elements, or such an art using organic LB film which is substantially an extremely thin film produced by applying "Langmuir-Blodgett's technique" process, for example. Based on these arts, a variety of multi-layer memory elements are under development. Nevertheless, actually, no art has ever successfully developed such a memory element fully satisfying those requirements mentioned above.

The object of the invention is to provide a novel high-performance three-dimensional integrated memory which is capable of fully satisfying those requirements mentioned above.

Inventors of this invention successfully developed a multi-layer memory element incorporating organic LB film and already filed applications for patents under the European Patent Application No. 89115861.0.

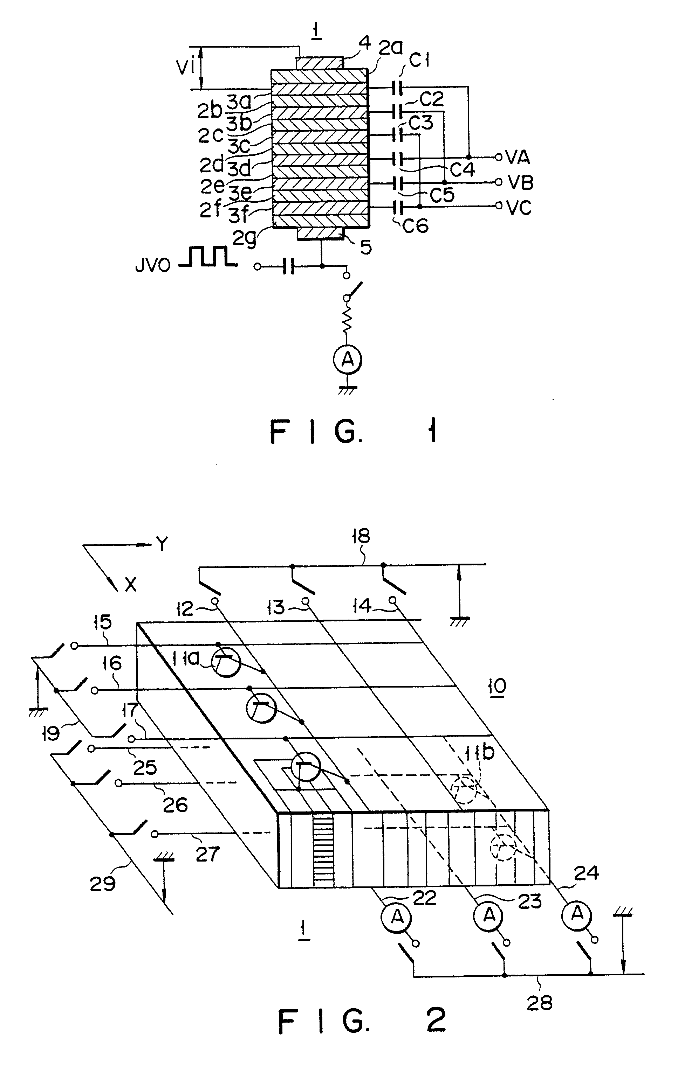

As shown in Fig. 1, the above multi-layer memory element is composed of organic LB film. A tunnel switch 1 is formed by alternately laminating a plurality of tunnel-switch films 2a through 2g (each containing conductive constant which is non-linearly variable by input voltage) and conductive layers 3a through 3f. A top electrode 4 is formed on the tunnel switch film 2a on the top of the tunnel switch 1, whereas a bottom electrode 5 is set below the tunnel switch film 2g which is substantially the bottom layer of the tunnel switch 1. When voltage Vi is applied between the top electrode 4 and the conductive layer 3a, data is written into the multi-layer memory element having the above structure. Electric charge is transmitted in the depthwise direction (i.e., in the direction of the bottom electrode 5) by providing conductive layers 3a through 3f with transmission-voltage pulses VA through VC containing phases different from each other. According to this multi-layer memory element, a high-density memory can be materialized, which can transmit electric charge in the depthwise direction.

Fig. 2 illustrates the schematic view of a three-dimensional integrated memory 10 which is provided with a number of those multi-layer memory elements mentioned above in the X and Y directions. This three-dimensional integrated memory 10 incorporates thin-film transistors 11a and 11b on both sides of each integrated memory element. Emitters of the thin-film transistors 11a are commonly connected in the X direction to upper wires 12 through 14. Bases of the transistors 11a are connected in the Y direction to upper wires 15 through 17. A write-address switches 18 are provided at one-ends of the upper X-wires 12 through 14. A write-address switches 19 are provided at one-ends of the upper Y-wires 15 through 17. Likewise, reading side of the integrated memory is provided with read-address switches 28 which are provided at one-ends of X-directional bottom wires 22 through 24, and read-address switches 29 which are provided at one-ends of the bottom wires 25 through 27, respectively.

The three-dimensional integrated memory 10 of the above structure can execute writing and reading operations by sequentially accessing an optional memory element 1 by referring to XY addresses. Compared to any conventional two-dimensional integrated memory available today, the three-dimensional integrated memory 10 can more densely integrate memory elements, and thus, memory capacity can gain further increment. Nevertheless, the three-dimensional integrated memory 10 sequentially accesses respective integral memory elements, and as a result, substantial time is needed for writing and reading data. This in turn prevents execution of writing and reading operations at a fast speed, thus it also raises problem.

This invention can be more fully understood from the following detailed description when taken in conjunction with the accompanying drawings, in which:

Fig. 1 is a cross-sectional view showing a multi-layer memory element based on the previously invented art;

Fig. 2 is a schematic perspective view showing a three-dimensional integrated memory embodied by the invention;

Fig. 3 is a perspective view schematically designating a three-dimensional integrated memory according to a first embodiment of the invention;

Fig. 4 is a view for showing the charge transmission direction of the three-dimensional memory of the first embodiment;

Fig. 5 is a circuit block diagram of the interface embodied by the invention;

Fig. 6 is a view for schematically showing a three-dimensional integrated memory of a second embodiment;

Fig. 7 is a circuit block diagram of the write/read interface embodied by the invention;

Fig. 8 is a conceptual diagram of a third embodiment of the invention;

Fig. 9 is a write circuit block diagram of the third embodiment of the invention;

Fig. 10 is a read circuit block diagram of the third embodiment of the invention;

Fig. 11 is a chart explanatory of the operation of the third embodiment of the invention;

Fig. 12 is a view of a modification of the write circuit of the third embodiment of the invention; and

Fig. 13 is a chart explanatory of the operation of the modification of the third embodiment shown in Fig. 12.

Referring now more particularly to the accompanying drawings, embodiments of the invention are described below.

Fig. 3 illustrates the conceptual diagram of the three-dimensional integrated memory related to the first embodiment of the invention. The reference numeral 30 shown in Fig. 3 designates a three-dimensional integrated memory which is integrally composed of a large number of three-dimensional multi-layer memory elements 30a by way of two-dimensional formation in the X and Y directions on an insulative interface substrate 40. Each of these three-dimensional multi-layer elements 30a is composed of alternately laminated tunnel switch films and conductive layers shown in Fig. 1 and connects each conductive layer to each electric-charge storing capacitor. By referring to Fig. 1, the substance of the three dimensional multi-layer element 30a has been described earlier, however, the composition itself and insulation between the adjacent elements are substantially identical to those already disclosed in the preceding Patent publication, and thus, further description is deleted here.

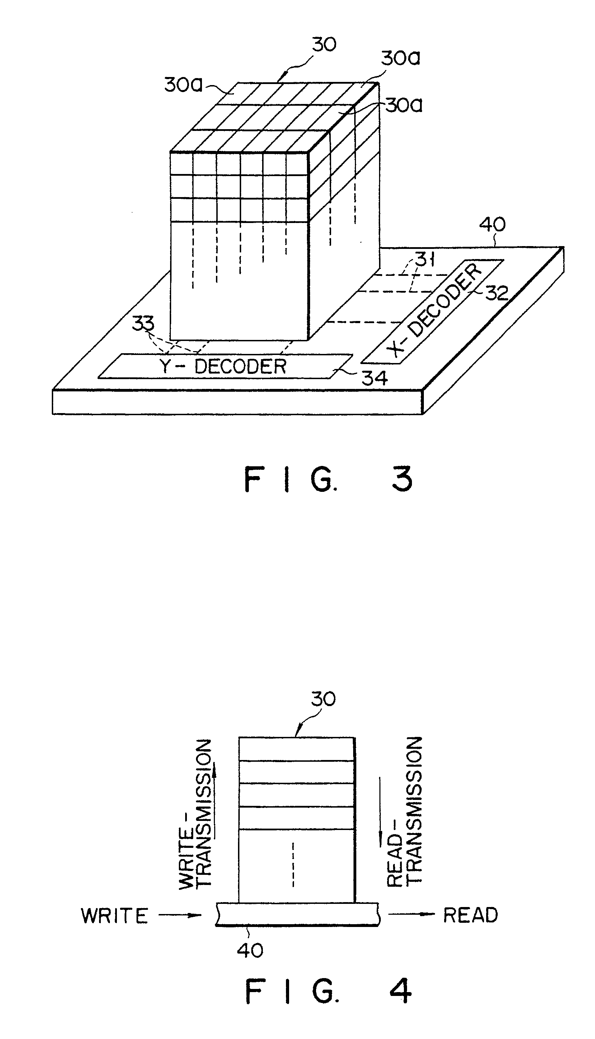

Each of those interfaces (to be described later on) is formed on the insulative interface substrate 40 under each of those three-dimensional multi-layer element 30a. All interfaces are connected to an X-decoder 32 via bit lines 31 and also to a Y-decoder 34 via word lines 33, respectively. Desirably, these X and Y decoders 32 and 34 are mounted on the insulative interface substrate 40. As a result, these interfaces and three-dimensional multi-layer elements 30a are respectively accessed by the X and Y decoders 32 and 34. As shown in Fig. 4, written data are transmitted en bloc per layer, which are then stored individually. These data stored in each layer is again output via respective interfaces.

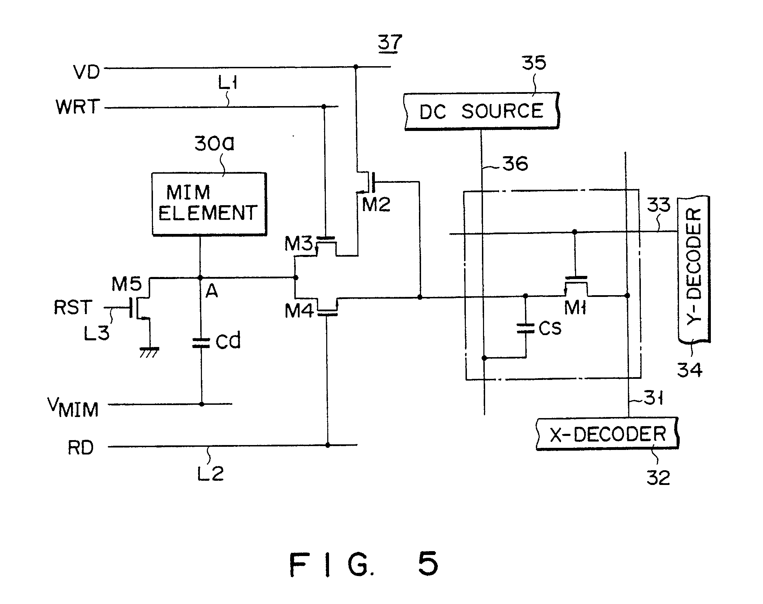

Fig. 5 illustrates the circuit block diagram of interface 37. The interface 37 incorporates the first through fifth switches M1 through M5 which are respectively composed of a thin-film transistor formed on the insulating substrate. Drain side of the first switch M1 is connected to the bit line 31, whereas the gate side is connected to the word line 33. The bit line 31 is connected to the X-decoder 32 which outputs data signal. The word line 33 is connected to the Y-decoder 34. These X and Y-decoders respectively appoint addresses of respective multi-layer memory elements 30a. The source side of the switch M1 is connected to one of electrodes of capacitor Cs and also to the gate side of the second switch M2. The other electrode of the capacitor Cs is connected to a DC-voltage power-supply source 35 through a plate line 36, which receives DC bias voltage. Voltage VD is constantly supplied to the drain side of the second switch M2 of which source side is connected to the drain side of the third switch M3. The gate side of the third switch M3 is connected to write-signal feeding line L1, whereas the source side of the switch M3 is connected to the drain sides of the fourth and fifth switches M4 and M5 and also to one of electrodes of an electric-charge-storing capacitor Cd (hereinafter called input/output capacitor) disposed at the bottom of the multi-layer memory element 30a (which is designated as MIM element in Fig. 5), respectively. Voltage VMIM corresponding to threshold voltage of data stored in the charge-storing input/output capacitor Cd is applied to the other electrode of this I/O capacitor Cd. The source side of the fourth switch M4 is connected to one of electrodes of the capacitor Cs, whereas the gate side of the switch M4 is connected to reading-signal (RD) feeding line L2. The gate side of the fifth switch M5 is connected to reset-signal (RST) feeding line L3, whereas the source side of the fifth switch M5 is grounded.

Next, the data writing and reading operations of the three-dimensional memory incorporating the above structure are described below.

When data writing operation is activated, first, data transmitted from bit lines is delivered to a selected interface containing addresses specified by the bit line 31 and word line 33, and then binary data "1" or "0" is written in the capacitor Cs. Next, reset signal is delivered to the gate of the fifth switch M5 so that the switch M5 can be turned ON to cause the input/output capacitor Cd to discharge the stored voltage. Next, reset signal RST is turned OFF to simultaneously turn the switch M5 OFF so that write signal WRT can be delivered to the gate of the third switch M3. Now, if binary signal "1" has been already written in the capacitor Cs, then the binary signal "1" is written into the input/output capacitor Cd via the second and third switches M2 and M3. Conversely, if binary signal "0" has been already written in the capacitor Cs, then the switch M2 remains OFF, and yet, since voltage VD is not delivered to one of electrodes of the input/output capacitor Cd, the signal "0" is written into the input/output capacitor Cd. The data writing operation is terminated by turning the write signal WRT OFF.

In other words, if the write signals WRT were simultaneously delivered to respective interface 37, then data can be written into respective multi-layer memory elements 30a simultaneously.

When data reading operation is activated, first, the X and Y-decoders respectively clear those capacitors Cs of all the interfaces to simultaneously turn the reset signal RST ON, and then clear the input/output capacitor Cd via the switch M5. Next, the reset signal RST is turned OFF, and then the switch M4 is turned ON on receipt of read signal RD. Now, if binary signal "1" has been already written in the input/output capacitor Cd, then binary signal "1" is also written into the input/output capacitor Cs, and as a result, the binary signal "1" appears in bit lines. Conversely, if binary signal "0" has been already written in the input/output capacitor Cd, then binary signal "0" is also written into the capacitor Cs, and as a result, the binary signal "0" appears in bit lines.

In other words, if the read signals RD were simultaneously delivered to respective interfaces 37, data can be read out of respective multi-layer memory elements 30a simultaneously. When the data-reading operation is underway, the write signal WRT remains LOW and the switch M3 remains OFF.

According to the first embodiment, since all the multi-layer memory elements 30a are integrated on the interface substrate 40, these memory elements are integrated together on the three-dimensional basis. Accordingly, the three-dimensional integrated memory embodied by the invention securely expands memory capacity incomparably to that of any conventional twodimensional memory elements available today.

Furthermore, each of the integrated multi-layer memory elements 30a is provided with an interface. This in turn allows the X and Y-decoders to preliminarily select specific interfaces to provisionally write optional data into them before simultaneously writing these data into all the multi-layer elements. Furthermore, since all the data can simultaneously be read out of the input/output capacitor which is substantially the electric-charge-storing capacity disposed at the bottom of the integrated multi-layer memory elements, data can be written and read at a faster speed than the conventional serial accessing.

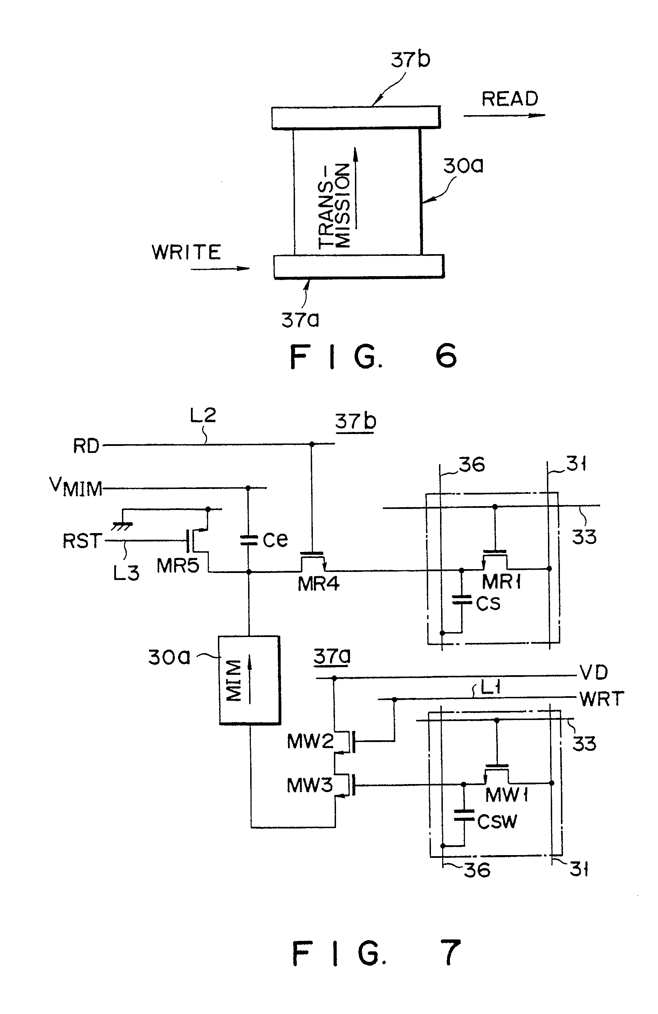

Fig. 6 illustrates the conceptual diagram of the three-dimensional integrated memory related to the second embodiment. The second embodiment provides such a three-dimensional integrated memory composed of laminated multi-layer memory elements on the twodimensional basis. A write interface 37a is connected to an end of the three-dimensional multi-layer memory element 30a. Likewise, a read interface 37b is connected to the other end of the three-dimensional multi-layer memory element 30a. This provides a "fast-in and fast-out" type memory.

Fig. 7 illustrates concrete structure of the write interface 37a and the read interface 37b. The write interface 37a is composed of switches MW1, MW2, MW3, and a capacitor Csw. The read interface 37b is composed of switches MR1, MR4, MR5, and capacitors Cs, Ce. Basically, these write and read inter-faces 37a and 37b are in the connection relationship identical to those interfaces shown in Fig. 5 except for the provision of the switch MW3 for the write interface 37a and the switch MR4 for the read interface 37b.

The three-dimensional integrated memory reflecting the second embodiment executes the data writing and reading operations in the same way as those of the first embodiment. In consequence, the second embodiment provides those functional performances identical to those of the first embodiment.

According to the three-dimensional integrated memory reflecting the second embodiment, since interfaces are provided for respective integrated multi-layer memory elements, the three-dimensional integrated memory can simultaneously write and read data at an extremely fast speed.

Next, the third embodiment of the three-dimensional integrated memory of the invention is described below.

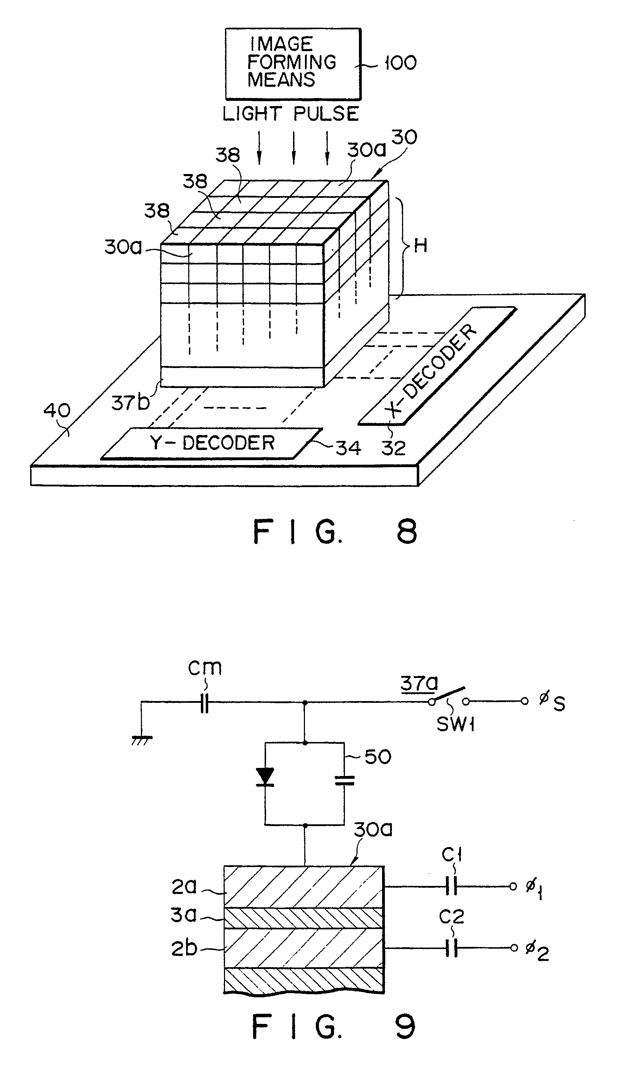

Fig. 8 illustrates the conceptual diagram of a light-input type three-dimensional integrated memory reflecting an embodiment of the invention. The light-input type three-dimensional integrated memory 30 is integrally composed of those multi-layer memory elements (described later on) on an identical substrate 40 on the two-dimensional basis. More particularly, the threedimensional integrated memory 30 is composed of the following; multi-layers H consisting of alternately laminated tunnel switch films and conductive films for storing data charge per layer, a photoelectric conversion layer 38 which is set to an end of the multi-layers H, an output circuit 37b (functioning as a data-reading means) which is set to the other end of the multi-layers H, and X/Y decoders 32 and 34 available for accessing optical memory cells of the output circuit 37b by applying X/Y address system.

Each of multi-layer memory elements 30a being the basic unit for composing the three-dimensional integrated memory of the invention has the structure composed of the following; alternately laminated tunnel switch films and conductive films, the photoelectric conversion layer 38 which is set to an end (composing data-writing means) of the multi-layer memory elements, the reading circuit 37b which is set to the other end (composing data-reading means) of the multi-layer memory elements, and a plurality of charge-storing capacitors which are respectively connected to each conductive layer of the integrated body. The multi-layer integrated memory elements 30a are respectively disposed in order that the photoelectric conversion films 38 can respectively be oriented in the direction identical to that of the integrated memory 30, in other words, in the direction to be flush with each other. By virtue of the disposition of these component elements, each of the photoelectric conversion films 38 can simultaneously receive light image or light pulse from image-forming means 100 like a lens for example.

Each of the photoelectric conversion layer 38 is composed of photoelectric conversion films of the integrated multi-layer memory elements. The multi-layer body H is composed of multi-layer memory elements. The output circuit 37b is composed of a plurality of reading circuits. If LB film were made available for composing the tunnel switch film, it is desired that organic film made from either phthalocyanine or merocyanine, or the like, be used for forming the photoelectric conversion film 38. On the other hand, when composing the tunnel switch film with organic film made from either $Al_2O_3$, or SiC, or the like, it is desired that the photo-electric conversion film 38 be composed of the compound of II - VI group elements and III - V group elements, or amorphous silicon film, for examples.

Fig. 9 illustrates the structure of the writing circuit 37a provided for each multi-layer memory element 30a. The reference numeral 50 designates a photo-electric conversion sensor having a specific value equivalent to photoelectric conversion layer. The reference numeral SW1 designates a reset switch which feeds reset pulse $\phi$s to the photoelectric conversion sensor 50. The reference character Cm designates a capacitor available for controlling the amount of electric charge generated in the photoelectric conversion sensor 50. If the photoelectric conversion sensor 50 composed of photovoltaic element were subject to electrical floating condition, due to influence of floating capacity of the photoelectric conversion sensor 50 itself, the amount of electric charge varies itself when the charge were generated by irradiated light.

To eliminate the effect of the floating capacity, the third embodiment provides a capacitor Cm containing substantial capacity and a predetermined capacitance value. Those electric-charge-storing capacitors Cl and C2 are respectively connected to conductive films 2a and 2b of respective multi-layer units which are connected to the photoelectric conversion sensor 50. Electric-charge transmitting pulses $\phi$1 and $\phi$2 are respectively transmitted to these conductive films 2a and 2b via the charge-storing capacitors C1 and C2.

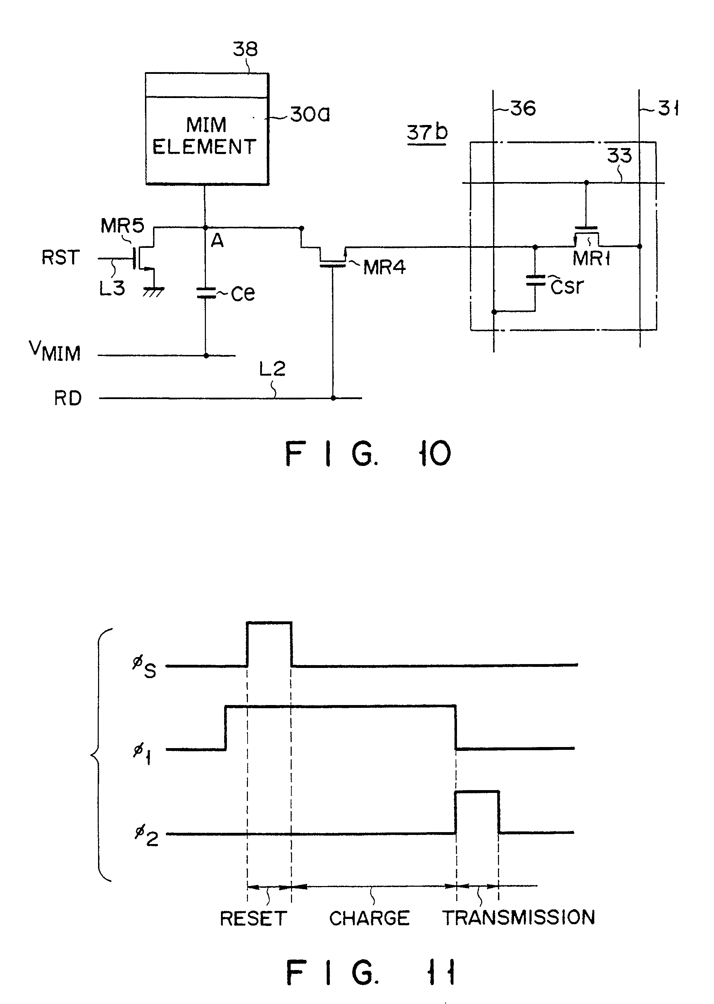

Fig. 10 illustrates the structure of each reading circuit composing output unit 37b. Substantially, the reading circuit shown in Fig. 10 is identical to the reading circuit shown in Fig. 7. The reading circuit has the structure described below.

The drain side of a switch MR1 is connected to a bit line 31, whereas the gate side is connected to a word line 33. The bit line 31 is connected to an X-decoder which outputs data signal, whereas the word line 33 is connected to a Y-decoder. The X and Y-decoders respectively appoint addresses of each multi-layer memory element. The source side of the switch MR1 is connected to one of electrodes of capacitor Csr and also to the source side of a switch MR4. The other electrode of the capacitor Csr is connected to a plate line 36 which receives DC bias voltage. A read-signal feeding line L2 is connected to the gate side of the switch MR4. The drain side of the switch MR4 is connected to one of electrodes of a charge-storing capacitor Ce which is disposed at the bottom of multi-layer memory element 30a (designated as MIM element 30a in Fig. 10). The drain side of the switch MR4 is connected to the drain side of a switch MR5. The gate side of the switch MR5 is connected to a reset-signal feeding line L3, whereas the source side is grounded. The other electrode of the capacitor Ce receives voltage MIM corresponding to threshold voltage of data stored in the capacitor Ce.

Next, the data-writing and reading operations of the three-dimensional memory element are described below.

When data-writing operation is entered, first, the switch SW1 is turned ON to feed reset pulse $\phi$s to the photoelectric conversion sensor 50 so that the sensor 50 itself can be reset. Next, while continuously feeding positive pulse $\phi_1$ to conductive film 2a connected to the photoelectric conversion sensor 50, optical image as image data is formed on the photoelectric conversion layers 38 by applying a lens for example. Then, irradiated light beam is converted into photoelectric charges by the photoelectric conversion sensor 50 connected to the multi-layer memory elements in the light-irradiated position to cause negative charges to be stored in a charge-storing capacitors $C_1$ of these multi-layer memory elements connected to the photoelectric conversion sensors 50. As a result, those optical data irradiated against the photoelectric conversion layers 38 are simultaneously written into charge-storing capacitors $C_1$ of the multi-layer memory elements.

After completing the writing of data charges into respective charge-storing capacitors $C_1$ of the multi-layer memory elements, the data charge per layer of the integrated memory is transmitted to a capacitor $C_2$. More particularly, by feeding voltage pulses $\phi_1$ and $\phi_2$ of different phases to the adjacent conductive films 2a and 2b via the tunnel switch film 3a, charge stored in the capacitor $C_1$ is conducted through the tunnel switch film 3a before being transmitted to the capacitor $C_2$. In this way, the written electric charge per layer is transmitted to the lower-layer charge-storing capacitor, and finally, the written charge is transmitted to the charge-storing capacitor right above the bottom layer.

When data-reading operation is entered, first, the X and Y-decoders respectively clear capacitors $C_{sr}$ of all the reading circuits, and then activate reset signal RST to clear capacitor $C_e$ via switch MR5. Next, the reset signal RST is turned OFF. Then, electric charge stored in those capacitors right above the bottom layer is transmitted to the charge-storing capacitor $C_e$ of the bottom layer. Next, switch MR4 is turned ON on receipt of read signal RD. Now, if binary signal "1" has been already written in the capacitor $C_e$, then the signal "1" is written into the capacitor $C_{sr}$, and then, the signal "1" appears in bit line 31. Conversely, if binary signal "0" has been already written in the capacitor $C_e$, then the signal "0" is written into the capacitor $C_{sr}$, and then, the signal "0" appears in the bit line 33.

Accordingly, when simultaneously transmitting read signals RD to all the reading circuits, data can simultaneously be read out of the integrated multilayer memory elements 30a.

According to the third embodiment of the invention, data charge is stored on the three-dimensional basis by integrating multi-layer memory elements. As a result, the three-dimensional integrated memory of the invention can securely provide more substantial memory capacity than that of any conventional two-dimensional integrated memories.

Furthermore, since the third embodiment provides a photoelectric conversion layer 38 on the writing side of the integrated memory elements so that data can be written by irradiation of light beam, data can securely be written into each of the integrated multi-layer memory element en bloc. In particular, when processing image data, a complete image can integrally be input by forming optical image on the photoelectric conversion layer 38. By virtue of this mechanism, time needed for the data writing operation is sharply saved.

Furthermore, since the third embodiment of the invention provides a plurality of reading circuits on the reading side of all the integrated multi-layer memory elements 30a, by simultaneously feeding the read signal RD to respective reading circuits, data can simultaneously be read out of respective multi-layer memory elements 30a at an extremely faster speed than any of the conventional serial accessing systems.

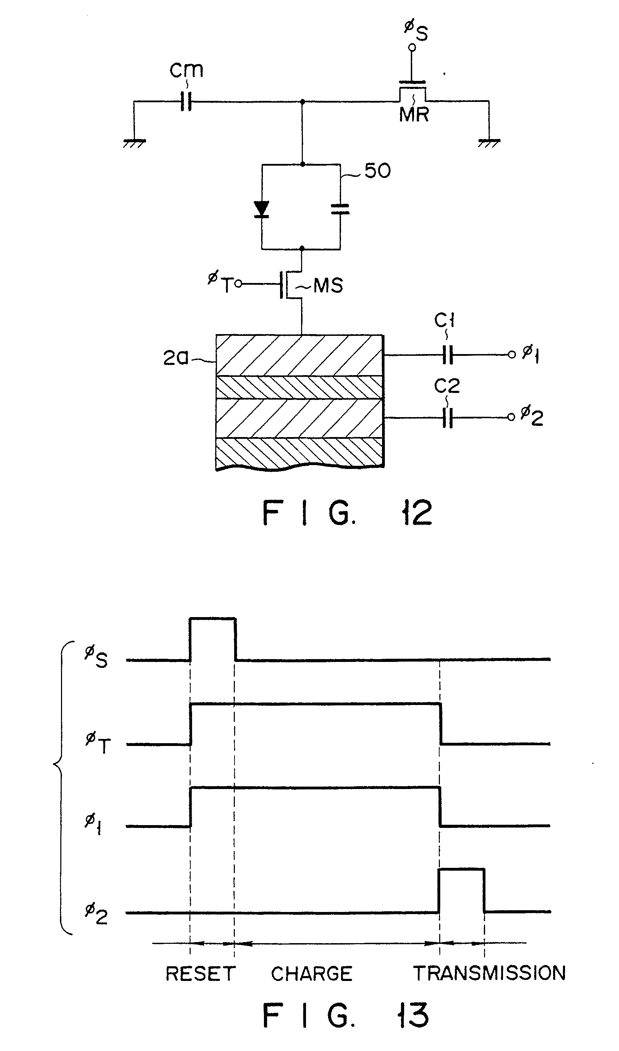

Referring now to Figs. 12 and 13, a variation of the third embodiment of the invention is described below. As shown in Fig. 12, a switch MS is provided between the photoelectric conversion sensor 50 and the upmost conductive layer 2a. Furthermore, a switch MR is provided in place of reset switch SW1. Where multi-layers are made from inorganic materials, it is desired that the switch MS is composed of a thin film transistor made from amorphous silicon or the like. On the other hand, where multi-layers are made from organic materials, it is desired that the switch MS is composed of an organic transistor made from field-polymerized polypyrrole, or the like. When operating the integrated memory unit featuring the above structure, the data-writing operation, data-reading operation, and transmission, are executed by feeding voltage pulses $\phi_s$, $\phi_T$, $\phi_1$, and $\phi_2$, based on the timing shown in Fig. 13.

The integrated memory as a variation of the third embodiment of the invention securely achieves such functional effect identical to the preceding embodiments described above, and yet, it can securely prevent error signal from entering into the system otherwise caused by incidence of unwanted light. Furthermore, even when irradiating light, electric charge can be transmitted merely by turning the switch MS OFF.

The photoelectric conversion film of the integrated memory shown in Figs. 9 and 12 is provided with a capacitor $C_m$. However, if the photoelectric conversion sensor 50 were composed of photoconductor, it is also possible for this embodiment to provide a constant voltage supply source in place of the capacitor $C_m$ so that electric charge from this power supply source can be fed to charge-storing capacitor $C_1$.

The three-dimensional integrated memory of the third embodiment provides photoelectric conversion layer on the writing side of multi-layer memory elements composed of alternately laminated tunnel switch films and conductive films, and yet, since a large number of multi-layer memory elements are integrally assembled by way of aligning those photoelectric conversion layers in the identical direction, by irradiating light beam which is substantially data supposed to be written into the photoelectric conversion layer, data can simultaneously be written into each multi-layer memory element, thus minimizing the writing time.

Furthermore, since a reading means is provided for the reading side of each multi-layer memory element, data stored in respective multi-layer memory element can simultaneously be read out of each layer en bloc, thus minimizing the reading time as well.

Those embodiments described above have respectively referred to the utilization of charge-storing capacitors of the multi-layer memory element for composing an input/output capacitor Cd. Nevertheless, it is also possible for these embodiments to provide capacitors outside of these multi-layer memory elements as required.

## Claims

1. A three-dimensional integrated memory which integrates a plurality of multi-layer memory elements (30a) each being composed of alternately laminated conductive films (3a to 3f) and tunnel switch films (2a to 2f) in matrix formation on an XY plane, comprising:
selective writing means (31 to 36, M1, CS) for selecting optional multi-layer memory elements one by one from said plurality of multi-layer memory elements, and outputting data signals to said selected multi-layer memory elements respectively; and
a plurality of interfaces (37) which are respectively set to one-ends of said integrated multilayer memory elements on the identical side, and which includ means (Cd) for storing the data signals, said plurality of interfaces including means (L1, M3) for simultaneously writing data signals stored in the storing means by applying a write signal into said plurality of multi-layer memory elements.

2. A three-dimensional integrated memory according to claim 1, characterized in that said interfaces (37) include means for simultaneously reading those data signals from said plurality of multi-layer memory elements by a read signal.

3. A three-dimensional integrated memory which integrates a plurality of multi-layer memory elements (30a) each being composed of alternately laminated conductive films (3a to 3f) and tunnel switch films (2a to 2f) in matrix formation on an XY plane, comprising:
a selective means (MW1, CSW) for selecting optional multi-layer memory elements from said plurality of multi-layer memory elements, and outputting a specific signal to said selected multi-layer memory elements;
a plurality of write-only interfaces (37a) which are respectively set to one-ends of said integrated multi-layer memory elements on the identical side, said plurality of write-only interfaces simultaneously writing those data stored by applying input signal from said selective-writing means into said plurality of multi-layer memory elements by means of write signal received from external sources; and
a plurality of read-only interfaces (37b) which are respectively set to the other one-ends of said plurality of multi-layer memory elements, said read-only interfaces simultaneously reading those data stored in said plurality of multi-layer memory elements by means of read signal received from external sources.

4. A three-dimensional integrated memory which writes data by irradiation of light beam functioning as write data into photoelectric conversion layer (38) characterized by comprising:
a plurality of multi-layer memory elements (30a) incorporating an assembly of multi-layers each being composed of alternately laminated conductive films (3a to 3f) and tunnel switch films (2a to 2f) and a plurality of photoelectric conversion layers (38) which are set to one-ends of said multi-layer assembly; and
a substrate (40) which supports said photoelectric conversion layers in the identical direction.

5. The three-dimensional integrated memory as set forth in claim 4, characterized by further comprising:
a plurality of reading means (37b) which are respectively set to the other one-ends of said plurality of multi-layer memory elements on the reading side, wherein said plurality of reading means simultaneously reading data stored in said multi-layer memory elements by means of read signal received from external sources.

6. A three-dimensional integrated memory device comprising:
a plurality of multi-layer memory elements (30a) incorporating an assembly of multi-layers each being composed of alternately laminated conductive films (3a to 3f) and tunnel switch films (2a to 2f) and a plurality of photoelectric conversion layers (38) which are set to one-ends of said multi-layer assembly;
a substrate (40) which supports said photoelectric conversion layers in the identical direction; and
means (100) for writing data into said memory elements by simultaneously irradiating light beam against said photoelectric conversion layers, characterized in that said light beam functions as write
data.

F I G. 1

F I G. 2

F I G. 3

F I G. 4

F I G. 5

F I G. 6

F I G. 7

F I G. 8

F I G. 9

13

F I G. 10

F I G. 11

14

F I G. 12

RESET     CHARGE     TRANSMISSION

F I G. 13